# EUROPEAN PATENT SPECIFICATION

(11) **EP 4 435 616 B1**
(45) Date of publication and mention of the grant of the patent: **30.09.2026**
(21) Application number: 24165116.5
(22) Date of filing: 21.03.2024
(51) Int. Cl.: G06F 13/16, G11C 29/02

(54) **STORAGE DEVICE INCLUDING BUFFER CHIP AND METHOD FOR PER-PIN TRAINING USING BUFFER CHIP**
SPEICHERVORRICHTUNG MIT PUFFERCHIP UND VERFAHREN ZUM TRAINIEREN PRO STIFT UNTER VERWENDUNG DES PUFFERCHIPS
DISPOSITIF DE STOCKAGE COMPRENANT UNE PUCE TAMPON ET PROCÉDÉ D'APPRENTISSAGE PAR BROCHE UTILISANT UNE PUCE TAMPON

(30) Priority: 23.03.2023 KR 20230038109
(43) Date of publication of application: 25.09.2024
(73) Proprietor: Samsung Electronics Co., Ltd., Suwon-si, Gyeonggi-do 16677 (KR)
(72) Inventor: KAVALA, Anil, Suwon-si, Gyeonggi-do 16677 (KR); JO, Youngmin, Suwon-si, Gyeonggi-do 16677 (KR); PARK, Jungjune, Suwon-si, Gyeonggi-do 16677 (KR); YOON, Chiweon, Suwon-si, Gyeonggi-do 16677 (KR)
(74) Representative: Kuhnen & Wacker Patent- und Rechtsanwaltsbüro PartG mbB

(56) References cited:
- US-A1- 2007 226 529
- US-A1- 2013 294 176
- US-A1- 2017 323 222
- US-A1- 2019 079 699
- US-A1- 2022 270 665

## Description

### BACKGROUND

The present disclosure relates to a storage device, and more particularly, to a method of performing per-pin training on a memory device using a buffer chip included in the storage device.

US 2019/079699 A1 discloses a memory system and a buffer device that includes a structure for performing training operations for a plurality of memory devices to ensure data reliability. A memory controller is configured to control a memory operation for a plurality of memory devices. A memory module includes the plurality of memory devices and a buffer device connected between the memory devices and the memory controller. Training operations for the memory devices to be performed by the buffer device including a training block with a signal delay circuit, and the memory controller performs the training operations by controlling the training block.

US 2007/226529 A1 discloses a memory controller comprises a DQ path, a DQS path, a delay element, a flip flop, and an adjustment unit. The DQ path receives and passes a data signal and outputs a delayed data signal. The DQS path receives and passes a data strobe signal. The delay element is coupled to the DQS path, receiving the data strobe signal to generate a compensated data strobe signal having a calibrated latency. The calibrated latency is determined by an adjustment signal. The flip flop is coupled to the data signal path and the delay element, sampling the delayed data signal by the compensated data strobe signal to generate an output data. The adjustment unit generates the adjustment signal according to the output data. The adjustment unit performs a calibration to adjust the adjustment signal, thus the calibrated latency is adjusted.

US 2017/323222 A1 discloses a method, system, and apparatus for determining optimal DQS delay for DDR memory interfaces. The method performs data eye training in a two-dimensional space with time delay value as x-axis and reference voltage, Vref, as y-axis to determine a rectangular data eye within an overall data eye with Vref margin. This document discloses the preamble of claim 1.

US 2013/294176 A1 discloses a control device that comprises a first data strobe input terminal to be connected in common to data strobe terminals that are included respectively in first memory devices, and a plurality of first sub-units each coupled to the first data strobe input terminal and each holding a data strobe delay value corresponding to an associated one of the first memory devices, and the data strobe delay values of the sub-units being independent from each other.

US 2022/270665 A1 discloses an application processor that includes a memory interface and a memory controller. The memory interface is connected to a semiconductor memory device through first data input/output, I/O, pads and second data I/O pads. The memory controller exchanges data with the semiconductor memory device by controlling the memory interface. The memory interface includes a training circuit to perform duty training of first data signals and second data signals by adjusting a duty of each of the first data signals with respect to a first reference voltage and adjusting a duty of each of the second data signals with respect to a second reference voltage.

Conventionally, communication within a storage device has been performed at a lower operating frequency compared to a memory system including a high-speed memory such as dynamic random access memory (DRAM) or static random access memory (SRAM). However, in recent years, communication within the storage device has been required to be performed at a high operating frequency. Accordingly, various methods of aligning communication signals have been introduced.

### SUMMARY

The invention is set out in the appended claims.

### BRIEF DESCRIPTION OF THE DRAWINGS

Various embodiments will be more clearly understood from the following detailed description taken in conjunction with the accompanying drawings, in which:
FIG. 1 is a schematic block diagram of a storage device;
FIG. 2 illustrates a memory device of the storage device of FIG. 1,
FIG. 3 is a block diagram illustrating a storage device ; wherein Fig.1 to 3 are examples not covered by the claims;
FIG. 4 is a schematic block diagram of a storage device according to an embodiment;
FIG. 5 is a block diagram illustrating a per-pin training operation of a buffer chip using a delay circuit ;
FIGS. 6A and 6B are block diagrams illustrating a per-pin training operation of a buffer chip using a duty control circuit ;
FIGS. 7A, 7B, 7C, and 7D are block diagrams illustrating a per-pin training operation of a buffer chip using a delay circuit, a reference voltage generator, a delay control circuit, and a duty control circuit, wherein fig.7A, 7B describe examples not covered by the claims, and fig.7C and 7D describe embodiments of the present invention;
FIG. 8 is a diagram for explaining a per-pin training operation performed in a storage device according to an embodiment;
FIGS. 9A and 9B are diagrams for explaining a delay training operation performed by a storage device using random data according to various embodiments;
FIG. 10 is a block diagram illustrating a storage device according to an example not covered by the claims;
FIGS. 11A and 11B are timing diagrams illustrating a reference voltage training operation in a buffer chip according to various embodiments;
FIG. 12 is a flowchart of per-pin training performed by a storage device according to an embodiment; and
FIG. 13 is a flowchart of an operation of performing per-pin training by using a buffer chip in a storage device according to an embodiment.

### DETAILED DESCRIPTION

A storage device may include a non-volatile memory and a controller for controlling the non-volatile memory. In the related art storage devices, communication between a non-volatile memory and a controller of the storage device has been performed at a lower operating frequency compared to a memory system including a high-speed memory such as dynamic random access memory (DRAM) or static random access memory (SRAM). However, in recent years, communication between the non-volatile memory and the controller has been required to be performed at a high operating frequency. Accordingly, various methods of aligning communication signals between the non-volatile memory and the controller have been introduced.

For example, the storage device may further include a buffer chip between the non-volatile memory device and the controller. The buffer chip may transmit/receive data and commands between the non-volatile memory device and the controller and may perform a control operation on the non-volatile memory device.

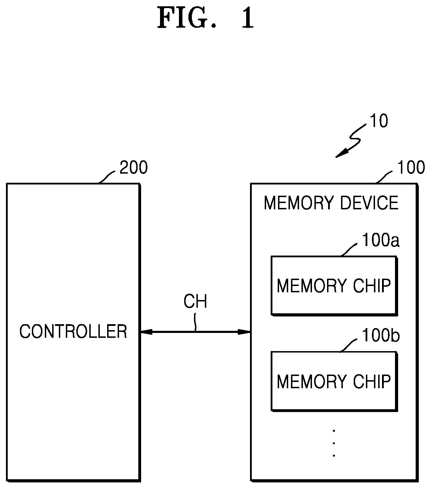

FIG. 1 is a schematic block diagram of a storage device.

Referring to FIG. 1, a storage device 10 may include a memory device 100 and a controller 200, and the memory device 100 may be a non-volatile memory device including a first memory chip 100a and a second memory chip 100b. The first and second memory chips 100a and 100b may be connected to the controller 200 through a channel CH which is the same for both the first and second memory chips 100a and 100b, and accordingly, the first and second memory chips 100a and 100b may transmit and receive data to and from the controller 200 through the same channel CH.

The memory device 100 may include a plurality of memory chips including at least the first and second memory chips 100a and 100b and may thus be referred to as a 'multi-chip memory'. For example, each of the first and second memory chips 100a and 100b may be a dual die package (DDP) or a quadruple die package (QDP). However, examples are not limited thereto, and in some examples, the memory device 100 may be implemented as a multi-die package including a plurality of memory dies including at least a first memory die and a second memory die. Descriptions of the first and second memory chips 100a and 100b below may be equally applied to the first and second memory dies.

When the memory device 100 is implemented as a multi-chip memory, the first and second memory chips 100a and 100b may operate simultaneously. For example, the controller 200 may simultaneously control read operations of the first and second memory chips 100a and 100b. As the data input/output speed between the controller 200 and the memory device 100 increases, the demand for phase alignment between the first and second memory chips 100a and 100b may increase.

According to some examples, the second memory chip 100b performs a phase correction operation based on the first memory chip 100a, so that the phases of the first and second signals respectively generated by the first and second memory chips 100a and 100b connected to the same channel CH may be aligned with one another, and thus, the performance and reliability of the memory device 100 may improve. In some examples, the memory device 100 may reduce the time required for the phase correction operation by simultaneously performing the duty correction operation and the phase correction operation in a training section, e.g., a duty cycle corrector (DCC) training section.

In some examples, each of the first and second memory chips 100a and 100b may be a non-volatile memory chip. For example, each of the first and second memory chips 100a and 100b may be a NAND flash memory chip. For example, at least one of the first and second memory chips 100a and 100b may be a vertical NAND (VNAND) flash memory chip, and a vertical NAND flash memory chip may include word lines vertically stacked on a substrate and cell strings each including a plurality of memory cells respectively connected to the word lines. However, examples are not limited thereto, and in some examples, at least one of the first and second memory chips 100a and 100b may be a resistive memory chip such as resistive RAM (ReRAM), phase change RAM (PRAM), or magnetic RAM (MRAM).

In some examples, the storage device 10 may be an internal memory embedded in an electronic device. For example, the storage device 10 may be a solid state drive (SSD), an embedded universal flash storage (UFS) memory device, and/or an embedded multi-media card (eMMC). In some embodiments, the storage device 10 may be an external memory removable from an electronic device. For example, the storage device 10 may be a UFS memory card, a Compact Flash (CF) memory card, Secure Digital (SD), a Micro Secure Digital (Micro-SD) memory card, a Mini Secure Digital (Mini-SD memory card, an extreme digital (xD) memory card or a memory stick.

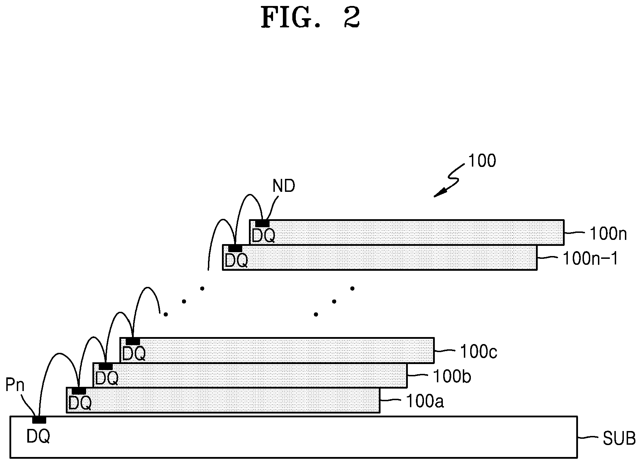

FIG. 2 illustrates the memory device 100 of the storage device 10 of FIG. 1, according to an examples.

Referring to FIG. 2, the memory device 100 may include a substrate SUB and a plurality of memory chips 100a to 100n. The plurality of memory chips 100a to 100n may be vertically stacked on the substrate SUB. Input/output pins Pn may be disposed on the substrate SUB, and input/output nodes ND of the plurality of memory chips 100a to 100n may be respectively connected to the input/output pins Pn. For example, the input/output pin Pn and the input/output nodes ND may be connected to each other through wire bonding, and in this configuration, for wire bonding, the plurality of memory chips 100a to 100n may be stacked with a skew in the horizontal direction, as illustrated in FIG. 2.

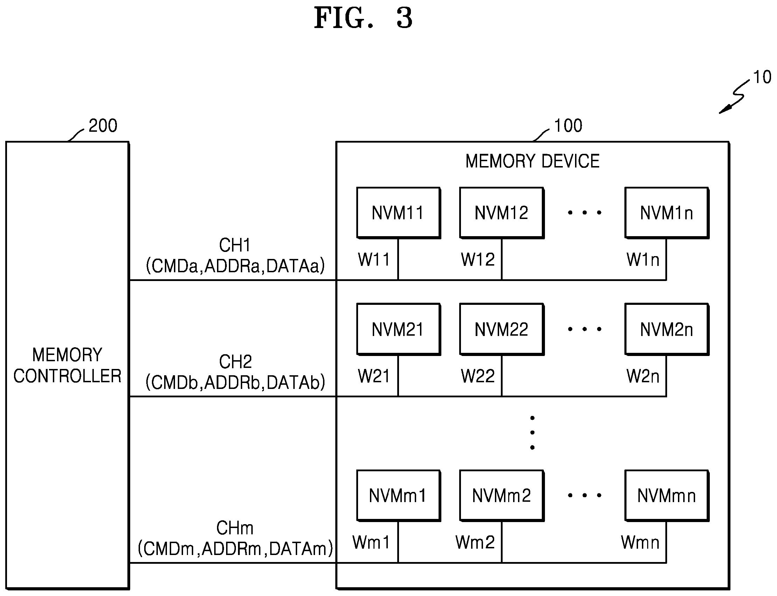

FIG. 3 is a block diagram illustrating a storage device according to an example.

Referring to FIG. 3, the storage device 10 may include a memory device 100 and a memory controller 200. The storage device 10 may support a plurality of channels CH1 to CHm, and the memory device 100 and the memory controller 200 may be connected through the plurality of channels CH1 to CHm. Here, m may be an integer of one or more. For example, in some examples, the storage device 10 may be implemented as a storage device such as an SSD.

The memory device 100 may include a plurality of non-volatile memory devices NVM11 to NVMmn. Here, n may be an integer of one or more. Each of the non-volatile memory devices NVM11 to NVMmn may be connected to one of the plurality of channels CH1 to CHm through a corresponding way. For example, the non-volatile memory devices NVM11 to NVM1n may be connected to the first channel CH1 through ways W11 to W1n, and the non-volatile memory devices NVM21 to NVM2n may be connected to the second channel CH2 through ways W21 to W2n. In an example, each of the non-volatile memory devices NVM11 to NVMmn may be implemented as a memory unit capable of operating according to individual commands from the memory controller 200. For example, each of the non-volatile memory devices NVM11 to NVMmn may be implemented as a chip or die, but examples are not limited thereto.

The memory controller 200 may transmit and receive signals to and from the memory device 100 through the plurality of channels CH1 to CHm. For example, the memory controller 200 may transmit commands CMDa to CMDm, addresses ADDRa to ADDRm, and data DATAa to DATAm to the memory device 100, or may receive data DATAa to DATAm from the memory device 100, through the channels CH1 to CHm, respectively.

The memory controller 200 may select one of non-volatile memory devices connected to a corresponding channel through each channel and transmit/receive signals to/from the selected non-volatile memory device. For example, the memory controller 200 may select a non-volatile memory device NVM11 from among non-volatile memory devices NVM11 to NVM1n connected to the first channel CH1. The memory controller 200 may transmit the command CMDa, the address ADDRa, and the data DATAa to the selected non-volatile memory device NVM11, or may receive data DATAa from the selected non-volatile memory device NVM11, through the first channel CH1.

The memory controller 200 may transmit and receive signals to and from the memory device 100 in parallel through different channels. For example, while the memory controller 200 transmits the command CMDa to the memory device 100 through the first channel CH1, the command CMDb may be transmitted to the memory device 100 through the second channel CH2. For example, while the memory controller 200 receives data DATAa from the memory device 100 through the first channel CH1, data DATAb may be received from the memory device 100 through the second channel CH2. Here, the term "in parallel" may mean that the memory controller 200 transmits, for example, the commands CMDa and CMDb to the memory device 100 starting at substantially the same time or may mean that there is at least some overlap in the transmission of the commands CMDa and CMDb to the memory device 100. Similarly, the term "in parallel" may mean that the memory controller 200 receives, for example, the data DATAa and DATAb from the memory device 100 starting at substantially the same time or may mean that there is at least some overlap in the reception of the data DATAa and DATAb from the memory device 100.

The memory controller 200 may control overall operations of the memory device 100. The memory controller 200 may control each of the non-volatile memory devices NVM11 to NVMmn connected to the channels CH1 to CHm by transmitting signals to the channels CH1 to CHm. For example, the memory controller 200 may control a selected one of the non-volatile memory devices NVM11 to NVM1n by transmitting the command CMDa and the address ADDRa through the first channel CH1.

Each of the non-volatile memory devices NVM11 to NVMmn may operate under the control by the memory controller 200. For example, the non-volatile memory device NVM11 may program data DATAa according to the command CMDa, address ADDRa, and data DATAa provided through the first channel CH1. For example, the non-volatile memory device NVM21 may read data DATAb according to the command CMDb and address ADDRb provided through the second channel CH2, and may transmit the read data DATAb to the memory controller 200.

Although FIG. 3 shows that the memory device 100 communicates with the memory controller 200 through m channels and includes n non-volatile memory devices corresponding to each channel, the number of channels and the number of non-volatile memory devices connected to one channel may be variously changed.

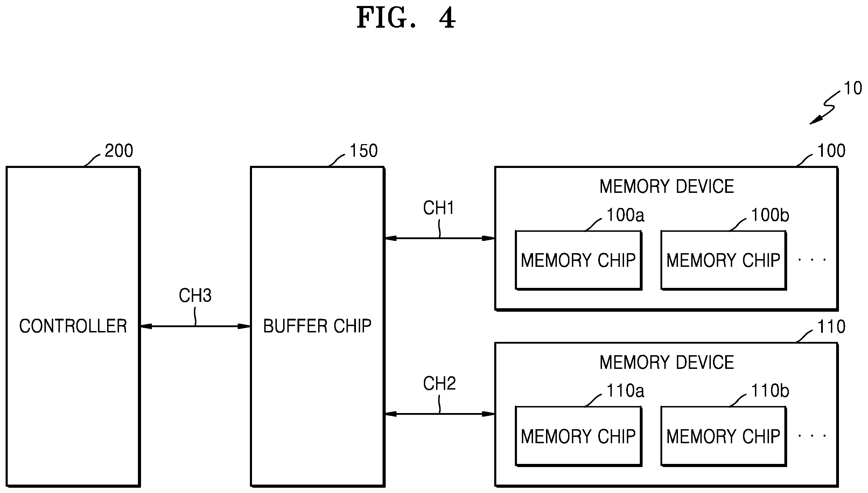

FIG. 4 is a schematic block diagram of a storage device according to an embodiment.

Referring to FIG. 4, the storage device 10 includes a buffer chip 150 and may include a first memory device 100 and a second memory device 110, and a controller 200. The number of memory devices that may be included in the storage device 10 is not limited to the number shown in FIG. 4 and the storage device may include a plurality of memory devices. The first memory device 100 may be connected to the buffer chip 150 through a first channel CH1, the second memory device 110 may be connected to the buffer chip 150 through a second channel CH2, and the buffer chip 150 may be connected to the controller 200 through the third channel CH3. The first memory device 100 includes a plurality of memory chips including at least first and second memory chips 100a and 100b, and accordingly, the plurality of memory chips including the at least first and second memory chips 100a and 100b may transmit and receive data to and from the buffer chip 150 through the first channel CH1. The second memory device 110 includes a plurality of memory chips including at least first and second memory chips 110a and 110b, and accordingly, the plurality of memory chips including the at least first and second memory chips 110a and 110b may transmit and receive data to and from the buffer chip 150 through the second channel CH2. The buffer chip 150 may transmit and receive data to and from the controller 200 through the third channel CH3. For example, the buffer chip 150 may transmit data received from the first memory device 100 and the second memory device 110 through the first channel CH1 and the second channel CH2, or transmit the data to the controller 200 through the third channel CH3, or transmit data received from the controller 200 through the third channel CH3 to the first memory device 100 and the second memory device 110 through the first channel CH1 and the second channel CH2. Hereinafter, an operation in which the storage device 10 performs per-pin training of the first and second memory devices 100 and 110 using the buffer chip 150 will be described in detail.

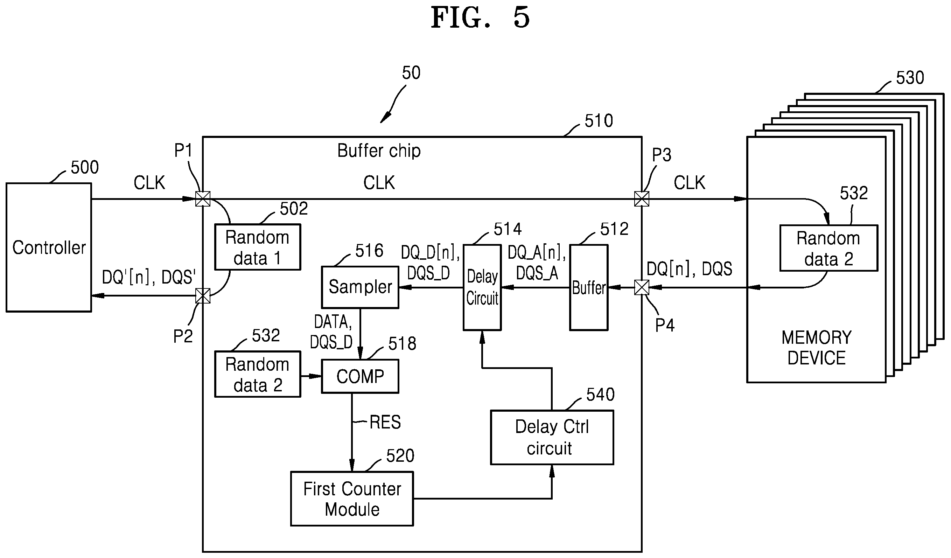

FIG. 5 is a block diagram illustrating a per-pin training operation of a buffer chip using a delay circuit according to an embodiment. FIG. 5 illustrates a storage device 50 including a controller 500, a buffer chip 510 and a plurality of memory devices 530. In some embodiments, the storage device 50, the controller 500, the buffer chip 510 and the plurality of memory devices 530 may correspond respectively to the storage device 10, the controller 200, the buffer chip 150 and the memory devices 110 and 110 illustrated and described with respect to FIG. 4.

The buffer chip 510 may include at least a first pin P1, a second pin P2, a third pin P3, and a fourth pin P4. The buffer chip 510 may receive a clock signal CLK from the controller 500 through the first pin P1 and may transmit a data signal DQ' [n] and a data strobe signal DQS' to the controller 500 through the second pin P2. The buffer chip 510 may transmit the clock signal CLK to the memory device 530 through the third pin P3 and may receive a data signal DQ[n] and a data strobe signal DQS from the memory device 530 through the fourth pin P4. For example, the second pin P2 and the fourth pin P4 may include 8 input/output pins, but embodiments are not limited thereto. The signal lines through which the clock signal CLK, data signals DQ[n] and DQ'[n], and data strobe signals DQS and DQS' are transmitted and received may constitute the channel CH of FIG. 1.

During a read operation on the buffer chip 510, the buffer chip 510 may receive the clock signal CLK, for example, a read enable signal nRE, from the controller 500 and outputs the data strobe signal DQS' and the data signal DQ'[n]. During a read operation on the memory device 530, the memory device 530 may receive the clock signal CLK, for example, a read enable signal nRE, from the buffer chip 510, and outputs the data strobe signal DQS and the data signal DQ[n]. In some embodiments, the clock signal CLK received by the buffer chip 510 from the controller 500 may be the same signal as the clock signal CLK received by the memory device 530 from the buffer chip 510.

The memory device 530 may return a preset signal to the buffer chip 510 in response to receiving the clock signal CLK, and the buffer chip 510 may return a preset signal to the controller 500 in response to receiving the clock signal CLK. When a preset signal is returned, the memory device 530 and the controller 500 may align and transmit phases of a plurality of signals. However, even if the phases of the signals are aligned at the time of transmission, during a communication process, noise may cause a skew in which a difference occurs at a point in time at which a plurality of signals arrive at a transmitter. In order for the device receiving the signal to sample the data signal DQ[n] to generate accurate data DATA, an optimal delay (1/4 t_ck) should be applied to the data strobe signal DQS. A delay for the data strobe signal DQS to accurately sample the data signal DQ[n] is referred to as a target delay. If the delay applied to the data strobe signal DQS is not the target delay or if the data skew is not addressed, the possibility that a communication error occurs in the storage device 50 may increase. Accordingly, a method of increasing communication accuracy between the controller 500, the buffer chip 510, and the memory device 530 is required. The storage device 50 may perform training to determine the alignment of the data signal DQ'[n] between the controller 500 and the buffer chip 510 and the target delay of the data strobe signal DQS', and performs training to determine the alignment of the data signal DQ[n] between the buffer chip 510 and the memory device 530 and the target delay of the data strobe signal DQS. The storage device 50 performs training (e.g., read training, and write training, etc.) to increase communication accuracy in performing all functions, and hereinafter, training for aligning the data signal DQ[n] and determining a target delay of the data strobe signal DQS will be described as delay training.

In a Double Data Rate (DDR) mode, the data signal DQ[n] may be sequentially sampled in synchronization with a rising edge and falling edge of the data strobe signal DQS generated based on the clock signal CLK. The data signal DQ[n] may be divided into a logic high section and a logic low section based on a reference voltage level. For example, a section higher than the reference voltage level in the data signal DQ[n] may be a logic high section, and a section lower than the reference voltage level may be a logic low section. Data windows of the data signal may be determined according to a ratio of the logic high section and the logic low section of the data sampled according to the data strobe signal DQS based on the reference voltage level.

If a "duty mismatch" occurs in the data signal DQ[n], the lengths of the logic high section and the logic low section of the data signal DQ[n] may be different from each other, that is, the ratio between the logic high section and the logic low section may not be 1:1. In this case, the data signals may have data windows having different lengths, and effective data windows of the data signals may decrease, and as a result, performance of the storage device 50 may deteriorate. Therefore, it is advantageous to secure an effective data window by performing duty correction based on the reference voltage level to resolve the duty mismatch of the data signal DQ[n]. According to some embodiments, the storage device 50 performs reference voltage training to determine a reference voltage level for resolving the duty mismatch. According to some embodiments, the storage device 50 performs duty cycle correction (DCC) training to eliminate a duty mismatch of the data signal DQ[n]. The storage device 50 may adjust the ratio of the logic high section and the logic low section to a desired ratio (e.g., 1:1) using the DCC training. The delay training, reference voltage training, and DCC training are performed for each of a plurality of pins through which signals are transmitted and received and hereinafter, delay training, reference voltage training, and DCC training are collectively referred to as per-pin training.

When the controller 500 performs per-pin training of the memory device 530 after completing the per-pin training of the buffer chip 510, the time used for per-pin training may be long and inefficient. To shorten the time for per-pin training, at the same time that the controller 500 performs per-pin training on the buffer chip 510, the buffer chip 510 performs hidden training on the memory device 530. In some embodiments, the clock signal CLK used by the controller 500 to train the buffer chip 510 and the clock signal CLK used by the buffer chip 510 to train the memory device 530 may be the same.

Referring to FIG. 5, the storage device 50 includes the controller 500, the buffer chip 510, and the memory device 530. The buffer chip 510 includes a buffer 512, a delay circuit 514, a sampler 516, a comparator (COMP) 518, a first counter module (COUNTER 1) 520, and may include a delay control (Ctrl) circuit 540. The first counter module 520 is a counter module for performing delay training, and includes a clock counter that controls internal operations of the first counter module 520, at least one bit counter that tracks bit changes under the control by the clock counter, and an averager. The delay control circuit 540 may transmit a command for the delay circuit 514 to delay the data signal DQ[n] and/or the data strobe signal DQS based on a signal received from the first counter module. The controller 500 and the buffer chip 510 may store first random data (Random Data 1) 502, and each of the memory device 530 and the buffer chip 510 stores second random data (Random Data 2) 532 that is different from the first random data 502. Random data is data in which a logic high section and a logic low section are randomly switched.

The controller 500 may transmit the clock signal CLK for per-pin training to the buffer chip 510. According to an embodiment, the controller 500 may transmit a clock signal CLK for per-pin training to the buffer chip 510 when the storage device 50 is powered on.

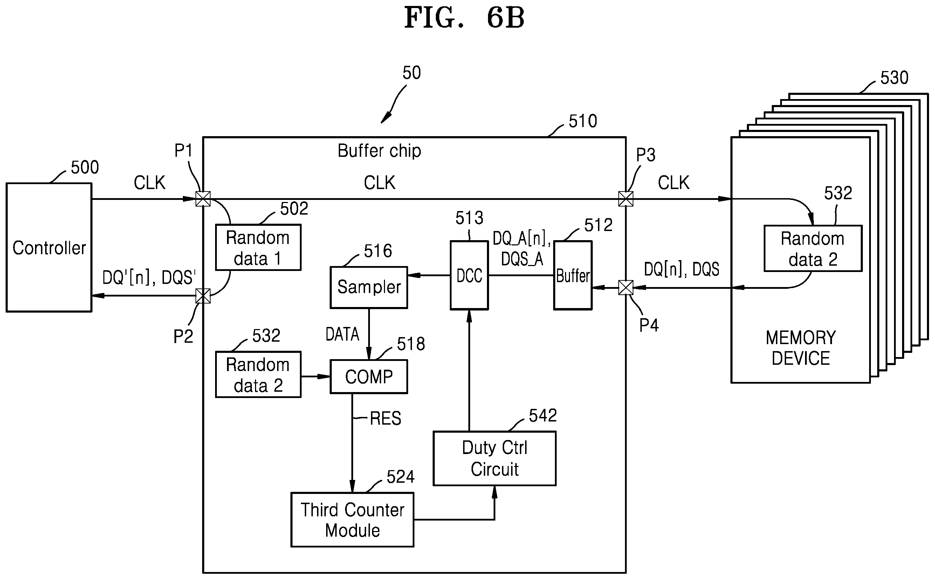

In response to receiving the clock signal CLK from the controller 500 through the first pin P1, the buffer chip 510 may determine a data signal DQ'[n] including at least a portion of the first random data 502. The buffer chip 510 may return the determined data signal DQ'[n] that is determined and the data strobe signal DQS' generated based on the clock signal CLK to the controller 500 through the second pin P2. According to the some embodiments, the buffer chip 510 further includes a duty cycle correction circuit (not shown in FIG. 5), and before the returning the determined data signal DQ' [n] and the data strobe signal DQS' to the controller 500, the buffer chip 510 may resolve the duty mismatch of the signal by using the duty cycle correction circuit. An embodiment in which the buffer chip 510 resolves a duty mismatch of a signal by using a duty cycle correction circuit will be described later in detail with reference to FIG. 6B.

For per-pin training of the memory device 530, the buffer chip 510 may transmit the clock signal CLK received from the controller 500 to the memory device 530 through a third pin P3. The memory device 530 may receive the clock signal CLK and determine a data signal DQ[n] including at least a part of the second random data 532. The memory device 530 may transmit the data strobe signal DQS generated based on the determined data signal DQ[n] and the clock signal CLK to the buffer chip 510. According to an embodiment, the memory device 530 may resolve a duty mismatch between the data signal DQ[n] and the data strobe signal DQS before transmitting the data signal DQ[n] and the data strobe signal DQS to the buffer chip 510. However, even if the memory device 530 resolves the duty mismatch during transmission, the duty mismatch may occur again during communication with (e.g., in the process of communicating with) the buffer chip 510.

The buffer chip 510 may receive the data signal DQ[n] and the data strobe signal DQS through the fourth pin P4. The buffer chip 510 may input the data signal DQ[n] and the data strobe signal DQS received through the fourth pin P4 to the buffer 512. For example, in some embodiments, the buffer 512 may include a plurality of buffers respectively buffering the data signal DQ[n] and the data strobe signal DQS. The buffer 512 temporarily stores the data signal DQ[n] and the data strobe signal DQS, and the buffer 512 transmits the amplified data signal DQ_A[n] and amplified data strobe signal DQS_A obtained by amplifying the data signal DQ[n] and the data strobe signal DQS to the delay circuit 514.

The delay circuit 514 delays the amplified data signal DQ_A[n] and the amplified data strobe signal DQS_A, so that the delayed data signal DQ_D[n] and the delayed data strobe signal DQS_D are transmitted to the sampler 516. For example, in some embodiments, the delay circuit 514 may include a plurality of delay circuits respectively delaying the amplified data signal DQ_A and the amplified data strobe signal DQS_A. The delay circuit 514 may delay the amplified data strobe signal DQS_A by a unit time to find a target delay of the data strobe signal DQS. The delay circuit 514 may adjust a delay time applied to the data strobe signal DQS in response to a signal received from the delay control circuit 540. For example, the delay circuit 514 may increase or decrease a delay time applied to the data strobe signal DQS in response to a signal received from the delay control circuit 540. The delay circuit 514 may adjust a target delay by repeatedly receiving a signal from the delay control circuit 540 and adding or removing a delay time by a unit time.

According to an embodiment, a phase difference may occur between the amplified data signals DQ_A[n] due to communication noise. Accordingly, the delay circuit 514 may align the phases of the data signals DQ[n] by adjusting the delay time for each data signal DQ[n]. For example, when the first data signal among the data signals DQ[n] is delayed by t seconds with respect to the second data signal among the data signals DQ[n], the delay circuit 514 may advance the first data signal by t seconds or apply a delay time by t seconds to the second data signal to align the phases of the first and second data signals.

The sampler 516 may obtain data DATA by sampling the data signal DQ[n] at the rising edge and the falling edge of the delayed data strobe signal DQS_D. Since the data signals DQa to DQn include a plurality of signals received through a plurality of channels, data DATAa to DATAn obtained by sampling the data signals DQa to DQn may also be plural. When a suitable delay time is applied to each data signal DQa to DQn and the data strobe signal DQS in the delay circuit 514, the data DATAa to DATAn obtained by the sampler 516 may be the same data as the second random data 532. The sampler 516 transmits the obtained data DATAa to DATAn to the comparator 518.

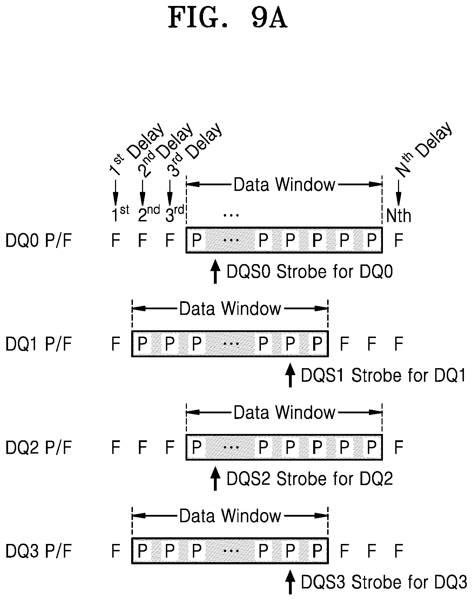

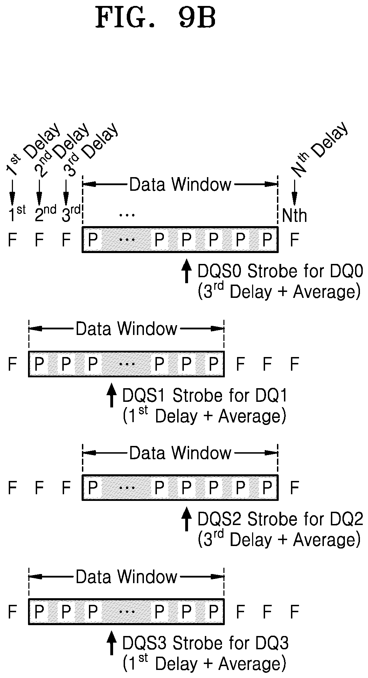

The comparator 518 compares the data DATAa to DATAn to the second random data 532. The comparator 518 checks whether the data DATAa to DATAn corresponding to the respective data signals DQa to DQn are the same as the second random data 532 to determine a pass/fail. The comparator 518 determines pass if the data signal DQ is equal to the second random data 532 and fail if the data signal DQ is not equal to the second random data 532. Since the delayed data strobe signal DQS_D and sampled data DATAa to DATAn based on the delayed data strobe signal DQS_D are sequentially input, the comparator 518 sequentially determines pass/fail. According to an embodiment, when the delay of the data strobe signal DQS sequentially increases, the pass/fail map may have a shape in which a fail section, a pass section, and a fail section appear sequentially. (See, e.g., FIG. 9A and 9B below). A pass section of the pass/fail map corresponds to a data window section, and a ratio of lengths of successive fail sections and pass sections means a duty cycle. The comparator 518 sequentially transmits, to the first counter module 520, the comparison result RES of the sampled data DATAa to DATAn and second random data 532 based on the delayed data strobe signal DQS_D.

The first counter module 520 determines a target delay using at least one bit counter and an averager. The first counter module 520 may receive the data strobe signal DQS and internally provide a clock signal CLK used for the operation of the first counter module 520. The first counter module 520 sequentially obtains a comparison result RES from the comparator 518. The first counter module 520 sequentially obtains the comparison result RES of the sampled data DATAa to DATAn and second random data 532 from the comparator 518 based on the delayed data strobe signal DQS_D. The first counter module 520 includes a first counter and a second counter. The first counter stores a first delay at a time point at which the comparison result RES is changed from fail to pass. For example, in some embodiments, the first counter may count a transition (e.g., may trip or toggle at a transition) from fail to pass as the first delay. The second counter stores a second delay when the comparison result RES is changed from pass to fail. For example, in some embodiments, the second counter may count a transition (e.g., may trip or toggle at a transition) from pass to fail as the second delay. (See, e.g., FIG. 9A). The first counter module 520 calculates the target delay by calculating an average value of the first delay stored in the first counter and the second delay stored in the second counter. Since the section between the first delay and the second delay is the pass window, the average value of the first delay and the second delay is the center of the pass window. Since the data strobe signal DQS is delayed by the determined target delay, when data is transmitted and received between the buffer chip 510 and the memory device 530, accuracy of the sampled data DATA is increased and the possibility of communication errors is reduced.

The delay control (Ctrl) circuit 540 may receive a signal from the first counter module 520 and may transmit a delay time increase signal to the delay circuit 514. According to an embodiment, the signal may include the target delay determined by the first control module 520. Since the target delay is determined by the first counter module 520 based on both the first delay and the second day, until the second delay is determined (i.e., until the comparison result RES changes from pass to fail) the first control module 520 does not output the signal including the target delay and the delay control circuit 540 outputs the delay time increase signal to the delay circuit 514. Once the second delay is determined by the first counter module 520, the first counter module 520 generates the target delay and transmits the signal including the target delay to the delay control circuit 540.

According to an embodiment, when at least one of the first delay and the second delay is not determined by the first counter module 520, the delay control circuit 540 may transmit a delay time increase signal to the delay circuit 514. When the second delay is determined, the first counter module 520 determines a target delay based on the first delay and the second delay and may transmit a signal indicating that the delay time has been determined to the delay control circuit 520. The delay control circuit 520 may not transmit a delay time increase signal to the delay circuit 514 in response to receiving the delay time determining signal.

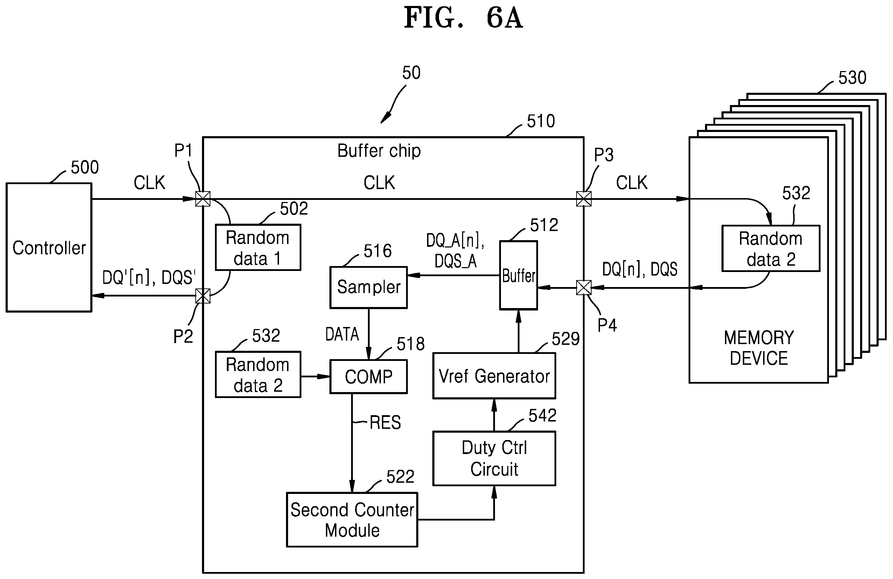

FIGS. 6A and 6B are block diagrams illustrating a per-pin training operation of a buffer chip using a duty control circuit according to various embodiments. FIG. 6A shows a per-pin training operation of a buffer chip using a reference voltage generator and a duty control circuit, according to an embodiment.

FIG. 6B shows a per-pin training operation of a buffer chip using a duty cycle correction circuit and a duty control circuit, according to an embodiment.

The storage device 50 may determine a logic high section and a logic low section of the data signal based on the reference voltage.

That is, the reference voltage may determine the duty cycle of the data signal DQ[n]. The storage device 50 may determine a section having a higher voltage level than the reference voltage among the data signals DQ[n] as a logic high section and determine a section having a voltage level lower than the reference voltage among the data signals DQ[n] as a logic low section. When the reference voltage is excessively high, the logic high section is shortened, and when the reference voltage is excessively low, the logic low section is shortened, resulting in signal distortion. Therefore, it is advantageous to properly determine the reference voltage level for signal integrity (SI). Hereinafter, a reference voltage level at which a ratio of a logic high section to a logic low section is 1:1 is referred to as a target reference voltage level. Referring to FIG. 6A, the buffer chip 510 includes a second counter module 522 and a reference voltage (Vref) generator 529, and may include a duty control (Ctrl) circuit 542.

The second counter module 522 may perform a counter operation for reference voltage training. For example, the second counter module 522 accumulates and stores the pass/fail status received from the comparator 518, and transmits a target reference voltage level determining signal to the duty control circuit 542 based on the accumulated pass/fail results. The duty control circuit 542 controls the reference voltage level by transmitting a reference voltage rising signal or a reference voltage falling signal to the reference voltage generator 529 based on the target reference voltage level determining signal received from the second counter module 522. The reference voltage generator 529 adjusts the reference voltage level. The reference voltage is input to the sampler 516 via the buffer 512, and the sampler 516 generates data DATA by sampling the data signal DQ[n] based on the reference voltage and the data strobe signal DQS. The comparator 518 compares the data DATA generated based on the reference voltage level with the second random data 532 to determine the pass/fail.

The comparator 518 determines a comparison result as pass when the data DATA generated based on the reference voltage level and the second random data 532 match and determines a comparison result as fail when the data DATA generated based on the reference voltage level and the second random data 532 do not match. The comparison result REF may be transferred to the reference voltage generator 529 through the second counter module 522 and the duty control circuit 542. The reference voltage generator 529 may sequentially increase (or decrease) the reference voltage.

For example, the reference voltage generator 529 may set an initial reference voltage close to a logic low level and sequentially increase subsequent reference voltages by a unit voltage. The reference voltage generator 529 adjusts the reference voltage based on the obtained comparison result. For example, the reference voltage generator 529 may check the duty cycle of the sampled data and adjust the reference voltage level so that the ratio of the logic high section to the logic low section is 1:1. The sampler 516 sequentially samples the data signal DQ[n] based on the sequentially changed reference voltage, and the comparator 518 sequentially compares the sampled data DATA with the second random data 532 to determine pass/fail to generate a pass/fail map. The second counter module 522 determines a target reference voltage level by obtaining a comparison result.

A plurality of bit counters included in the second counter module 522 store a first reference voltage level at the time point at which the comparison result is changed from fail to pass, and a second reference voltage level at a time point at which the comparison result is changed from pass to fail. The averager calculates an average value based on the first reference voltage level and the second reference voltage level. An average value of the first reference voltage level and the second reference voltage level is a target reference voltage level such that a ratio of a logic high section and a logic low section of the data signal DQ[n] is 1:1.

Referring to FIG. 6B, the buffer chip 510 includes a third counter module 524, and includes a duty control (Ctrl) circuit 542 and a duty cycle corrector circuit (DCC) 513.

The third counter module 524 may perform a counter operation for DCC training. The third counter module 524 accumulates and stores pass/fail information received from the comparator 518 and transmit the accumulated pass/fail result to the duty control circuit 542. The duty control circuit 542 transmits a DCC control signal to the DCC 513 based on the pass/fail result received from the second counter module 522, so that a ratio of a logic high section and a logic low section of the sampled data signal is controlled. The DCC 513 performs an operation of correcting the duty of the data signal using various methods.

For example, in some embodiments, the DCC 513 may correct the duty of the data signal using a phase interpolation method. The DCC 513 may adjust the length ratio of the logic high section and logic low section of the data signal in stages, so that the ratio of the logic high section and the logic low section of the data signal may be controlled to be a desired ratio.

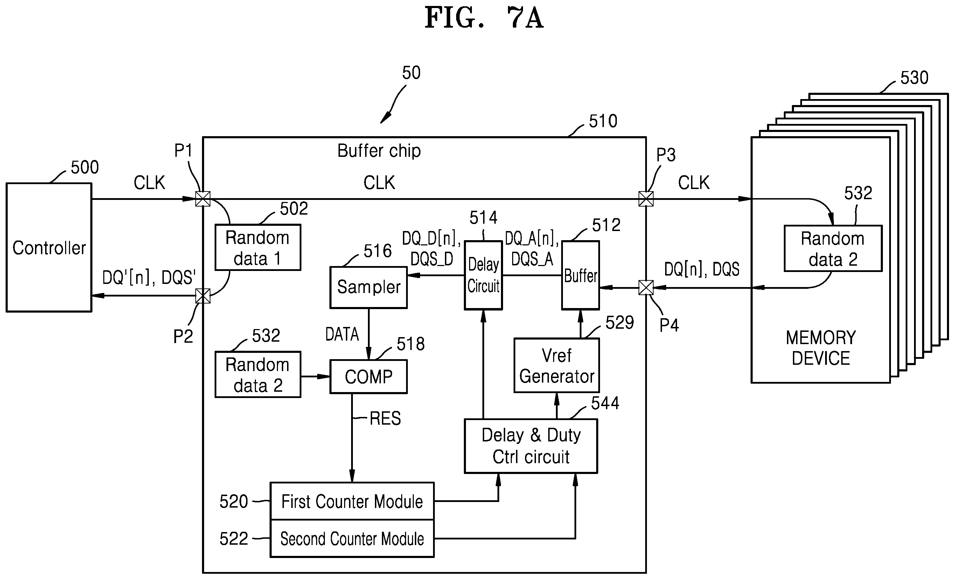

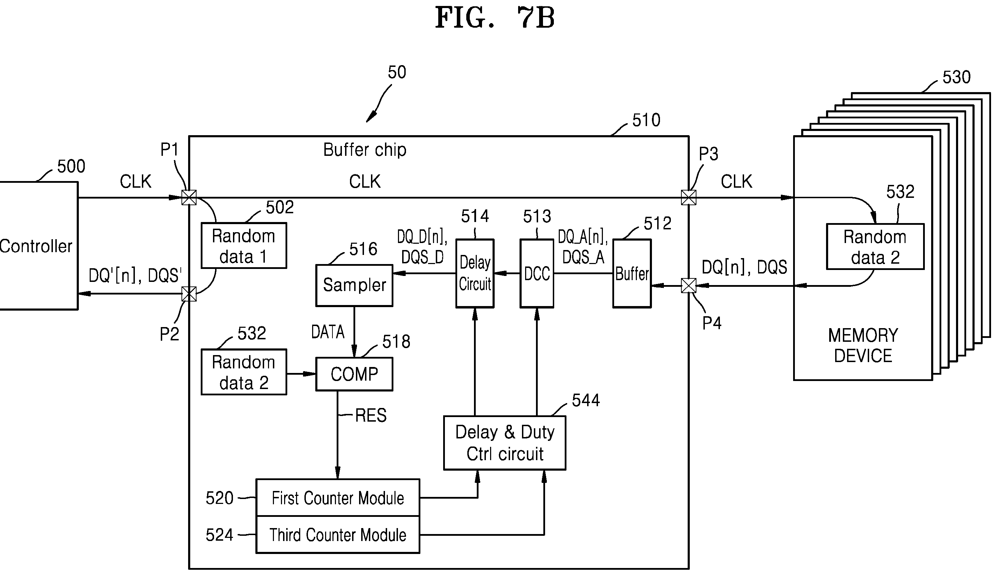

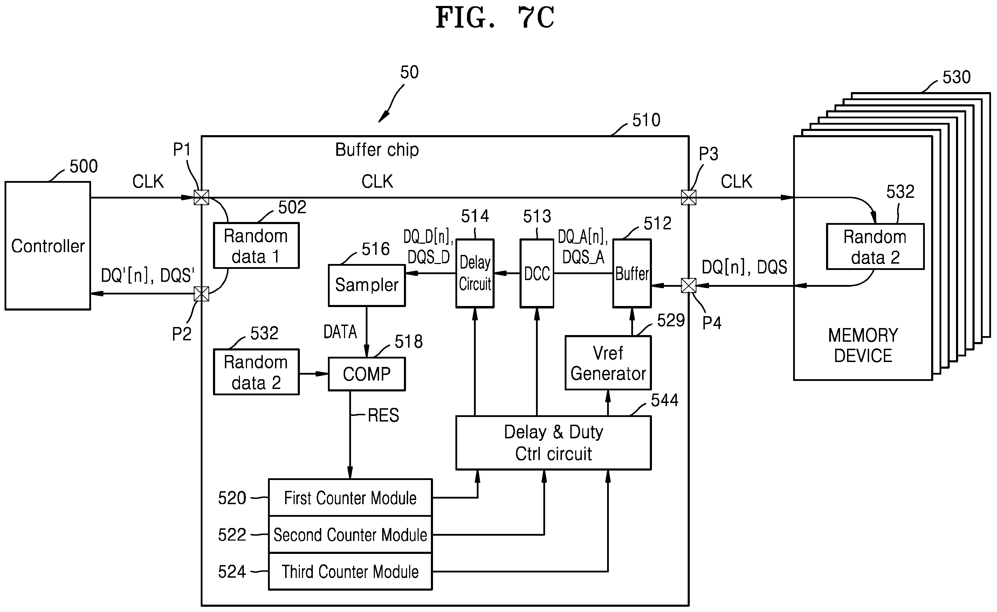

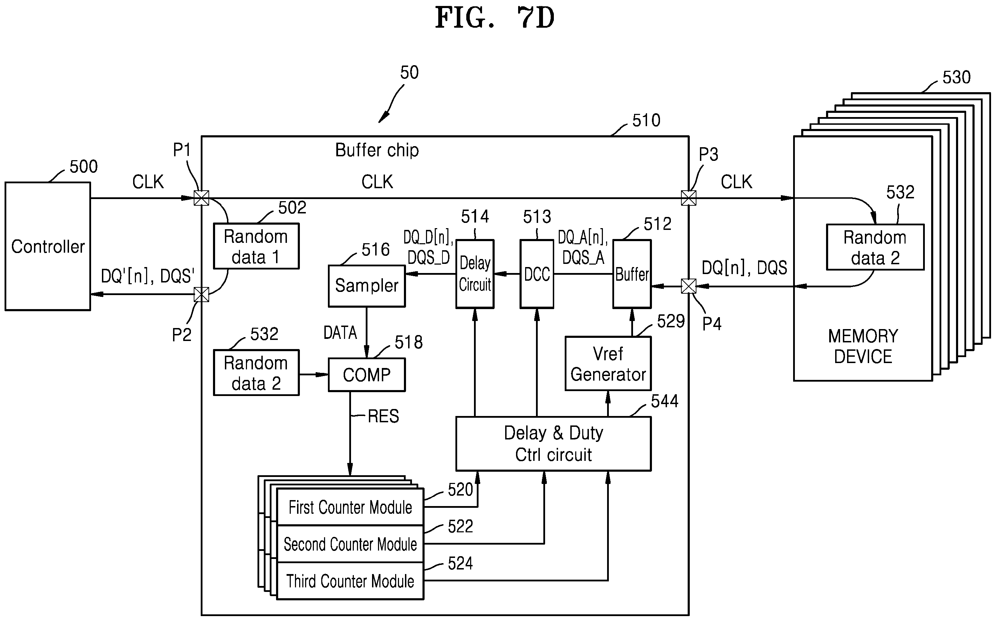

FIGS. 7A, 7B, 7C, and 7D are block diagrams illustrating a per-pin training operation of a buffer chip using a delay circuit, a reference voltage generator, a delay control circuit, and a duty control circuit , wherein fig.7A, 7B describe examples not covered by the claims, and fig.7C and 7D describe embodiments of the present invention.

Descriptions of the same contents as those described in FIGS. 5, 6A, and 6B will be omitted for conciseness. Referring to FIG. 7A, the buffer chip 510 includes both a delay circuit 514 and a reference voltage (Vref) generator 529.

The buffer chip 510 may include a delay & duty control (Ctrl) circuit 544 for performing delay training using the delay circuit 514 and reference voltage training using the reference voltage generator 529. The delay circuit 514 adjusts delay times of the data signal DQ[n] and the data strobe signal DQS to eliminate skew and adjust a time point for sampling the data signal DQ[n]. The reference voltage generator 529 performs duty cycle correction of the data signal DQ[n] by adjusting the reference voltage level. If the comparator 518 in FIGS. 5, 6A, and 6B determines a comparison result for one factor (e.g., delay time-pass or fail or a reference voltage level-pass or fail), the comparator 518 in FIG. 7A determines a comparison result for two factors (delay time & reference voltage level - pass or fail).

For example, the comparator 518 may generate a look-up table mapping pass/fail results for arbitrary combinations of delay times and reference voltage levels. The buffer chip 510 may include a first counter module 520 for delay training and a second counter module 522 for reference voltage training.

The first counter module 520 is used to determine the alignment of the data signal DQ[n] and/or the target delay of the data strobe signal, and the second counter module 522 is used to determine the target reference voltage level. As described above, the first counter module 520 stores the first delay time at a time point at which the pass/fail result according to the delay time is changed from fail to pass, and the second delay time of the time point at which the pass/fail result according to the delay time changes from pass to fail. The first counter module 520 determines a target delay based on the first delay time and the second delay time. The second counter module 522 stores the first reference voltage level at a time point at which the pass/fail result according to the reference voltage level is changed from fail to pass, and the second reference voltage level at the time point at which the pass/fail result according to the reference voltage level changes from pass to fail. The second counter module 522 determines the target reference voltage level by calculating an average value of the first reference voltage level and the second reference voltage level.

Referring to FIG. 7B, the buffer chip 510 may include both a delay circuit 514 and a DCC 513.

The buffer chip 510 may include a delay & duty control (Ctrl) circuit 544 for performing delay training using the delay circuit 514 and DCC training using the DCC 513. The buffer chip 510 may improve signal integrity more efficiently by using the delay circuit 514 and the DCC 513 similarly to that described with reference to FIG. 7A.

Referring to FIG. 7C, the buffer chip 510 includes a delay circuit 514, a DCC 513, and a reference voltage (Vref) generator 529.

In some embodiments, the buffer chip 510 may include a delay & duty control circuit 544 for performing delay training using the delay circuit 514, DCC training using the DCC 513, and reference voltage training using the reference voltage generator 529. The buffer chip 510 improves signal integrity more efficiently by using the delay circuit 514, the DCC 513, and the reference voltage generator 529, similarly to FIG. 7A.

Referring to FIG. 7D, in some embodiments, the buffer chip 510 may include a plurality of counter modules corresponding to multi-die packaging.

Multi-die packaging is technology for producing semiconductors by integrating a plurality of dies in one package. In some embodiments, the buffer chip 510 may include a plurality of the first counter modules 520, a plurality of the second counter modules 522, and a plurality of the third counter modules 524, so that the training method using the delay circuit 514, the DCC 513, and the reference voltage generator 529 described with reference to FIGS. 5 to 7C may be applied to each memory die.

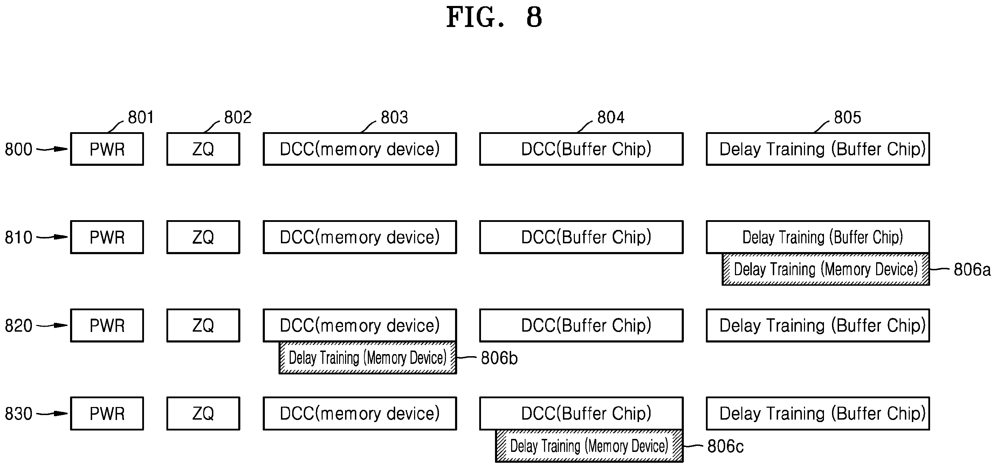

FIG. 8 is a diagram for explaining a per-pin training operation performed in a storage device according to an embodiment.

The process 800 according to a comparative example according to the related art may, after power-on 801 of the storage device, sequentially perform ZQ calibration 802, DCC training 803 in the memory device, and DCC training 804 and delay training 805 (e.g., read training and/or write training) in the buffer chip.

In process 800, delay training for the memory device may be performed only after the delay training 805 for the buffer chip is completed. By contrast, in the per-pin training method according to various embodiments, delay training between a buffer chip and a memory device may be performed at various time points.

Referring to FIG. 8, in the per-pin training method according to various embodiments, delay training between a buffer chip and a memory device may be performed at various time points. For example, in process 810 of an embodiment, delay training 806b of the memory device (e.g., hidden read training) may be performed while delay training is performed on the buffer chip. In process 820 of an embodiment, delay training 806b between the buffer chip and the memory device may be performed while DCC training 803 is performed on the memory device. In process 830 of an embodiment, delay training 806c between the buffer chip and the memory device may be performed while DCC training 804 is performed on the buffer chip. In the process 800 according to the related art, since the controller manages all training, two delay trainings cannot be performed at the same time. By contrast, in the per-pin training method according to various embodiments, since delay training for a memory device may be performed in a buffer chip, two delay trainings may be performed simultaneously. Accordingly, the time required for training the storage device including the buffer chip is reduced.

FIGS. 9A and 9B are diagrams for explaining a delay training operation performed by a storage device using random data according to an embodiment.

FIG. 9A shows a pass/fail map of the data signal DQ[n] and an edge (rising edge or falling edge) of the data strobe signal DQS before per-pin training is performed.

As described with reference to FIGS. 5 to 7D, the counter module may generate a pass/fail map of the data signal DQ[n] based on the obtained comparison result RES.

The first data signal DQ0 has a data window (pass window) of 4^{th} delay to N-1^{th} delay, the data window of the second data signal DQ1 is 2^{th} delay to N-3^{th} delay, the data window of the third data signal DQ2 may be 4^{th} delay to N-1^{th} delay, and the data window of the fourth data signal DQ3 may be 2^{th} delay to N-3^{th} delay. Although only four data signals are shown in FIGS. 9A and 9B, embodiments are not limited thereto. Before performing per-pin training, the edge of the data strobe signal may be located out of the center of the data window. For example, referring to FIG. 9A, positions of the first data strobe signal DQS0 and the third data strobe signal DQS2 may be a position deviated from the center of the data window of the first data signal DQ0 and the third data signal DQ2 to the left. Positions of the second data strobe signal DQS 1 and the fourth data strobe signal DQS3 may be a location deviated from the center of the data window of the second data signal DQ1 and the fourth data signal DQ3 to the right. Accordingly, an error may occur when sampling the data signal DQ.

FIG. 9B shows a pass/fail map of the data signal DQ[n] and an edge of the data strobe signal DQS after per-pin training is performed.

Referring to FIG. 9B, after per-pin training is performed, the position of the data strobe signal may be located at the center of the data window of each data signal.

The counter module (e.g., the counter module 520 of FIG. 5) determines target delays of the data strobe signals DQS0 to DQS3 of the respective data signals DQ0 to DQ3 using the average of the delay times obtained from the first counter and the second counter. Thus, the buffer chip 510 applies a target delay to the existing data strobe signal. The counter module applies a target delay to the existing data strobe signal, so that the edge position of the data strobe signal is adjusted to minimize the possibility of error in data sampling. For example, referring to FIG. 9B, the edge of the first data strobe signal DQS0 may be changed to be located in the center of the data window of the first data signal DQ0, the edge of the second data strobe signal DQS1 may be changed to be located at the center of the data window of the second data signal DQ1, the edge of the third data strobe signal DQS2 may be changed to be located at the center of a data window of the third data signal DQ2, and the edge of the fourth data strobe signal DQS3 may be located at the center of a data window of the fourth data signal DQ3.

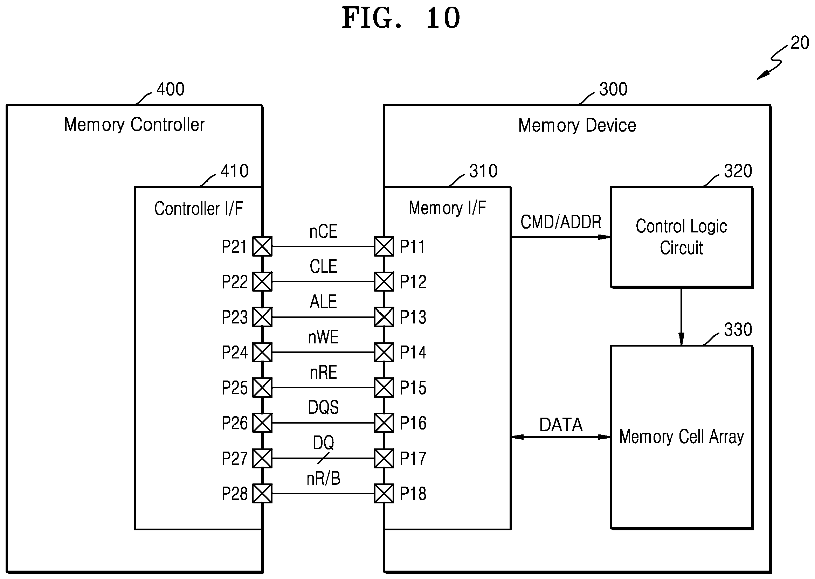

FIG. 10 is a block diagram illustrating a storage device according to an example not covered by the claims.

Referring to FIG. 10, a storage device 20 may include a memory device 300 and a memory controller 400.

The memory device 300 may correspond to one of the non-volatile memory devices NVM11 to NVMmn communicating with the memory controller 200 based on one of the plurality of channels CH1 to CHm of FIG. 3. The memory controller 400 may correspond to the memory controller 200 of FIG. 3. The memory device 300 may include first to eighth pins P11 to P18, a memory interface I/F 310, a control logic circuit 320, and a memory cell array 330.

The memory I/F 310 may receive the chip enable signal nCE from the memory controller 400 through the first pin P11.

The memory I/F 310 may transmit/receive signals to/from the memory controller 400 through the second to eighth pins P12 to P18 according to the chip enable signal nCE. For example, when the chip enable signal nCE is in an enable state (e.g., low level), the memory I/F 310 may transmit/receive signals to/from the memory controller 400 through the second to eighth pins P12 to P18. The memory I/F 310 may receive a command latch enable signal CLE, an address latch enable signal ALE, and a write enable signal nWE from the memory controller 400 through the second to fourth pins P12 to P14.

The memory I/F 310 may receive the data signal DQ from the memory controller 400 through the seventh pin P17 or transmit the data signal DQ to the memory controller 400. A command CMD, an address ADDR, and data may be transmitted through the data signal DQ. For example, the data signal DQ may be transmitted through a plurality of data signal lines. In this case, the seventh pin P17 may include a plurality of pins corresponding to a plurality of data signals. The memory I/F 310 may obtain the command CMD from the data signal DQ received in the enable section (e.g., high level state) of the command latch enable signal CLE based on the toggle timings of the write enable signal nWE.

The memory I/F 310 may obtain the address ADDR from the data signal DQ received in the enable section (e.g., high level state) of the address latch enable signal ALE based on the toggle timings of the write enable signal nWE. In an example, the write enable signal nWE may be toggled between a high level and a low level while maintaining a static state (e.g., a high level or a low level).

For example, the write enable signal nWE may be toggled in a section in which the command CMD or the address ADDR is transmitted. Accordingly, the memory I/F 310 may obtain the command CMD or the address ADDR based on the toggle timings of the write enable signal nWE. The memory I/F 310 may receive the read enable signal nRE from the memory controller 400 through the fifth pin P15.

The memory I/F 310 may receive the data strobe signal DQS from the memory controller 400 or transmit the data strobe signal DQS to the memory controller 400 through the sixth pin P16. In the data output operation of the memory device 300, the memory I/F 310 may receive the read enable signal nRE toggling through the fifth pin P15 before outputting the data DATA.

The memory I/F 310 may generate a toggling data strobe signal DQS based on the toggling of the read enable signal nRE. For example, the memory I/F 310 may generate a data strobe signal DQS that starts toggling after a preset delay (e.g., tDQSRE) based on the toggling start time of the read enable signal nRE. The memory I/F 310 may transmit the data signal DQ including the data DATA based on the toggle timing of the data strobe signal DQS. Accordingly, the data DATA may be aligned with the toggle timing of the data strobe signal DQS and transmitted to the memory controller 400. In the data input operation of the memory device 300, when the data signal DQ including the data DATA is received from the memory controller 400, the memory I/F 310 may receive the data strobe signal DQS toggling together with the data DATA from the memory controller 400.

The memory interface I/F 310 may obtain data DATA from the data signal DQ based on the toggle timing of the data strobe signal DQS. For example, the memory I/F 310 may obtain the data DATA by sampling the data signal DQ at rising edges and falling edges of the data strobe signal DQS. The memory I/F 310 may transmit the ready/busy output signal nR/B to the memory controller 400 through the eighth pin P18.

The memory I/F 310 may transmit state information of the memory device 300 to the memory controller 400 through the ready/busy output signal nR/B. When the memory device 300 is in a busy state (i.e., when internal operations of the memory device 300 are being performed), the memory I/F 310 may transmit a ready/busy output signal nR/B indicating a busy state to the memory controller 400. When the memory device 300 is in a ready state (i.e., when internal operations of the memory device 300 are not performed or completed), the memory I/F 310 may transmit a ready/busy output signal nR/B indicating a ready state to the memory controller 400. For example, while the memory device 300 reads data DATA from the memory cell array 330 in response to a page read command, the memory I/F 300 may transmit a ready/busy output signal nR/B indicating a busy state (e.g., a low level) to the memory controller 400. For example, while the memory device 300 programs data DATA into the memory cell array 330 in response to a program command, the memory I/F 310 may transmit a ready/busy output signal nR/B indicating a busy state to the memory controller 400. The control logic circuit 320 may generally control various operations of the memory device 300.

The control logic circuit 320 may receive a command/address CMD/ADDR from the memory I/F 310. The control logic circuit 320 may generate control signals for controlling other components of the memory device 300 according to the received command/address CMD/ADDR. For example, the control logic circuit 320 may generate various control signals for programming data DATA in the memory cell array 330 or reading data DATA from the memory cell array 330. The memory cell array 330 may store data DATA obtained from the memory I/F 310 under the control by the control logic circuit 320.

The memory cell array 330 may output the stored data DATA to the memory I/F 310 under the control by the control logic circuit 320. The memory cell array 330 may include a plurality of memory cells.

For example, the plurality of memory cells may be flash memory cells. However, examples are not limited thereto, and the memory cells may be a resistive random access memory (RRAM) cell, a ferroelectric random access memory (FRAM) cell, a phase change random access memory (PRAM) cell, a thyristor random access memory (TRAM) cell, or a magnetic random access memory (MRAM) cell. Hereinafter, embodiments will be described focusing on an embodiment in which the memory cells are NAND flash memory cells. The memory controller 400 may include first to eighth pins P21 to P28 and a controller I/F 410.

The first to eighth pins P21 to P28 may correspond to the first to eighth pins P11 to P18 of the memory device 300. The controller I/F 410 may transmit the chip enable signal nCE to the memory device 300 through the first pin P21.

The controller I/F 410 may transmit/receive signals with the memory device 300 selected through the chip enable signal nCE through second to eighth pins P22 to P28. The controller I/F 410 may transmit a command latch enable signal CLE, an address latch enable signal ALE, and a write enable signal nWE to the memory device 300 through the second to fourth pins P22 to P24.

The controller I/F 410 may transmit the data signal DQ to the memory device 300 or receive the data signal DQ from the memory device 300 through the seventh pin P27. The controller I/F 410 may transmit a data signal DQ including a command CMD or an address ADDR together with a toggle write enable signal nWE to the memory device 300.

As the command latch enable signal CLE having an enable state is transmitted, the controller I/F 410 transmits a data signal DQ including a command CMD to the memory device 300, and as the address latch enable signal ALE having an enable state is transmitted, the controller I/F 410 may transmit the data signal DQ including the address ADDR to the memory device 300. The controller I/F 410 may transmit the read enable signal nRE to the memory device 300 through the fifth pin P25.

The controller I/F 410 may receive the data strobe signal DQS from the memory device 300 or may transmit the data strobe signal DQS to the memory device 300 through the sixth pin P26. In the data output operation of the memory device 300, the controller I/F 410 may generate a toggle read enable signal nRE and transmit the read enable signal nRE to the memory device 300.

For example, the controller I/F 410 may generate a read enable signal nRE that is changed from a fixed state (e.g., high level or low level) to a toggle state before data DATA is output. Accordingly, the data strobe signal DQS toggling based on the read enable signal nRE in the memory device 300 may be generated. The controller I/F 410 may receive the data signal DQ including the data DATA together with the toggling data strobe signal DQS from the memory device 300. The controller I/F 410 may acquire data DATA from the data signal DQ based on the toggle timing of the data strobe signal DQS. In a data input operation of the memory device 300, the controller I/F 410 may generate a toggle data strobe signal DQS.

For example, the controller I/F 410 may generate a data strobe signal DQS that changes from a fixed state (e.g., high level or low level) to a toggle state before transmitting data DATA. The controller I/F 410 may transmit the data signal DQ including the data DATA to the memory device 300 based on the toggle timings of the data strobe signal DQS. The controller I/F 410 may receive the ready/busy output signal nR/B from the memory device 300 through the eighth pin P28.

The controller I/F 410 may determine state information of the memory device 300 based on the ready/busy output signal nR/B.

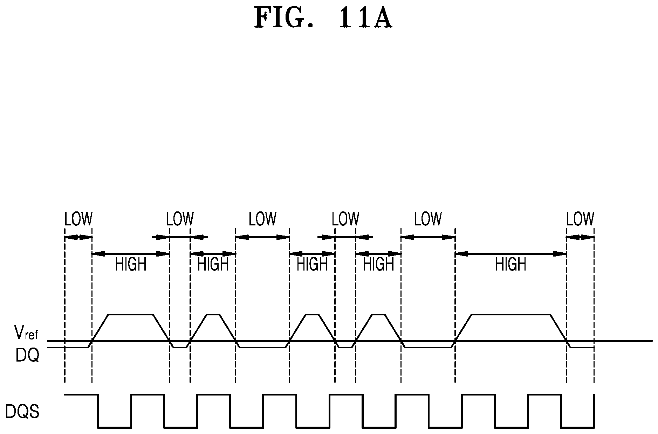

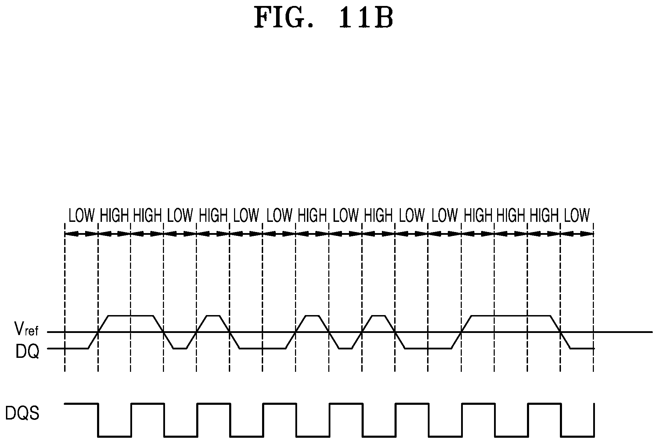

FIGS. 11A and 11B are timing diagrams illustrating a reference voltage training operation in a buffer chip according to an embodiment.

FIG. 11A shows a data signal DQ, a data strobe signal DQS and a reference voltage level Vref.

The sampler may determine a section higher than the reference voltage level of the data signal DQ as a logic high section HIGH and a section lower than the reference voltage level as a logic low section LOW. In FIG. 11A, since the reference voltage level is lower than a target reference voltage level, the logic low section LOW may appear shorter than the logic high section HIGH. Logic-low data may be mistaken for logic-high data if data is sampled when the reference voltage level is lower than the target reference voltage level. Conversely, although not shown, when the reference voltage level is higher than the target reference voltage level, the logic low section LOW may appear longer than the logic high section HIGH. Logic-high data may be mistaken for logic-low data if data is sampled when the reference voltage level is higher than the target reference voltage level. When the reference voltage level is higher or lower than the target reference voltage level, the duty cycle is not 1:1, so there is a high probability of error in data sampling. Therefore, to prevent data from being misjudged, the reference voltage level needs to be changed to a target level.

FIG. 11B shows a case where the reference voltage level is the target reference voltage level.

When the reference voltage level is the target level, the duty cycle may appear as 1:1. Referring to FIG. 11B, it may be seen that the lengths of the logic high section HIGH and the logic low section LOW are similar. The reference voltage generator (e.g., the reference voltage generator 529 of FIG. 6) of various embodiments performs duty cycle correction by changing the reference voltage level to a target level.

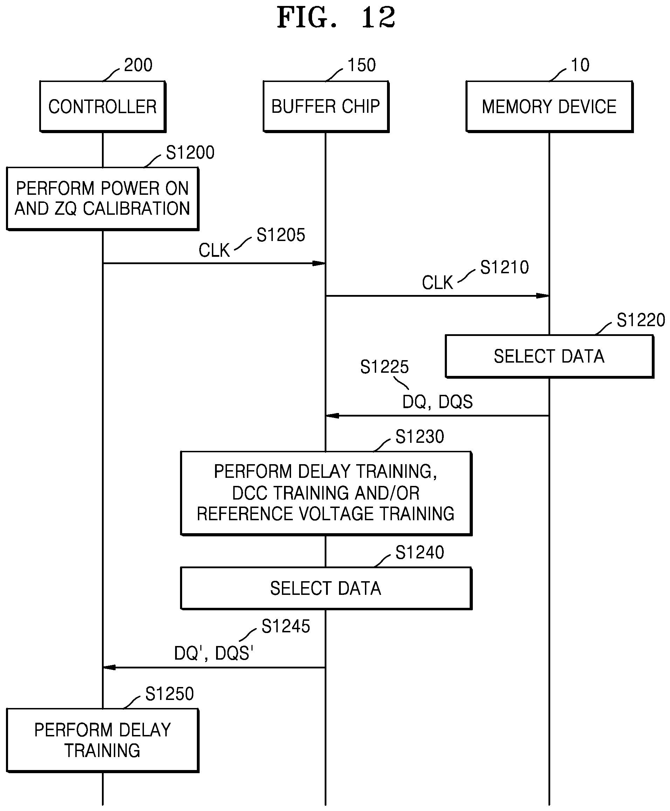

FIG. 12 is a flowchart of per-pin training performed by a storage device, according to an embodiment. For example, the per-pin training may be performed between a controller 200, a buffer chip 150 and a memory device 10 according to an embodiment.

Per-pin training between the buffer chip 150 and the memory device 10 may be performed at various time points as described in FIG. 8, and FIG. 12 describes an embodiment in which per-pin training is performed between a time point at which DCC training is performed in the memory device 10 and a time point at which DCC training is performed in the buffer chip 150.

The controller 200 may perform power-on of the storage device and perform ZQ calibration S1200. For example, the controller 200 may detect power-on of the storage device and, in response to detecting power-on of the storage device, may perform ZA calibration.

After performing the ZQ calibration, the controller 200 may transmit a clock signal CLK to the buffer chip 150 in operation S1205. For example, the clock signal CLK may be nRE and may be for delay training of the buffer chip 150. The buffer chip 150 may transmit the clock signal CLK received from the controller 200 to the memory device 10 in operation S1210.

The memory device 10 may receive the clock signal CLK and select data in operation S1220. For example, the memory device 10 may select at least a portion of the second random data. The memory device 10 may transmit the data signal DQ and the data strobe signal DQS to the buffer chip 150 in operation S1225. For example, the memory device 10 may transmit the data signal DQ including the at least part of the second random data to the buffer chip 150.

The buffer chip 150 receives the data signal DQ and the data strobe signal DQS and perform delay training, DCC training, and/or reference voltage training in operation S1230. The buffer chip 150 samples the data signal DQ and compares the sampled data DATA with the second random data by sequentially adding a delay to the data signal strobe signal DQS. According to an embodiment, the buffer chip 150 may sequentially increase the reference voltage level of the data signal DQ and compares the sampled data DATA with the second random data. The buffer chip 150 may generate a pass/fail map of the data signal DQ based on a comparison result between the data DATA and the second random data. The buffer chip 150 determines a target delay and a target reference voltage level based on the generated pass/fail map.

After completing delay training, DCC training, and/or reference voltage training for the memory device, the buffer chip 150 may select data in operation S1240. For example, the buffer chip 150 may select at least a portion of first random data.

The buffer chip 150 may transmit a data signal DQ'[n] and a data strobe signal DQS' to the controller 200 in operation S1245. For example, the buffer chip 150 may transmit the data signal SQ'[n] including the at least a portion of the first random data and the data strobe signal DQS' based on the clock signal to the controller 200. The controller 200 may perform delay training in operation S1250. For example, the controller 200 may perform delay training on the buffer chip150 based on the received data signal DQ'[n] and the data strobe signal DQS' in operation S1250.

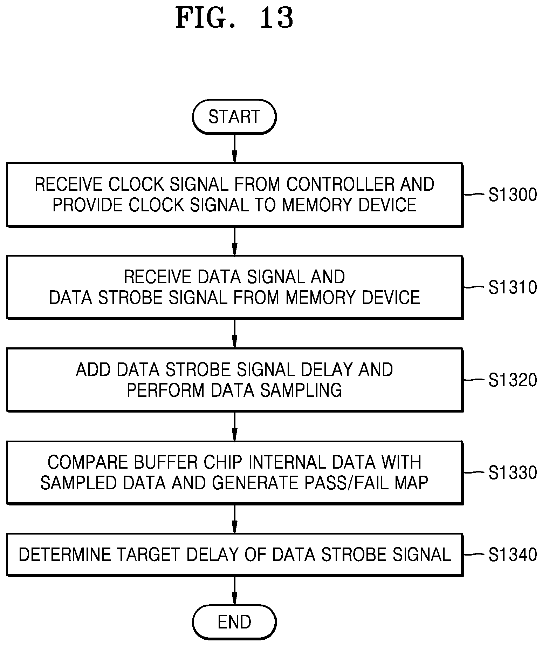

FIG. 13 is a flowchart of an operation of performing per-pin training by using a buffer chip in a storage device according to an embodiment. According to various embodiments, the operation of performing per-pin training may be implemented by the storage device 10 or the storage device 50 illustrated with respect to FIGS. 4-6B and FIGS. 7C-7D and described above.

In operation S1300, the buffer chip may receive a clock signal from the controller and provide the clock signal to the memory device.

For example, the buffer chip may receive the read enable signal nRE acquired from the controller and provide the read enable signal nRE to the memory device.

In operation S1310, the buffer chip receives a data signal and a data strobe signal from the memory device. The memory device transmits a data signal including at least a portion of the second random data to the buffer chip. The buffer chip may receive a data signal and a data strobe signal through an input buffer.

In operation S1320, the buffer chip adds a delay strobe signal delay and perform data sampling. The buffer chip adds a delay to the data strobe signal in the delay circuit and samples the data signal based on the delayed data strobe signal. The sampled data may be synchronized to the rising or falling edge of the delayed data strobe signal.

In operation S1330, the buffer chip compares internal data with sampled data and may generate a pass/fail map. The buffer chip compares internal data that is internal to the buffer chip with sampled data and may generate the pass/fail map. The buffer chip determines a pass when the sampled data and internal data are the same, and a fail when the sampled data and internal data are different. The buffer chip may sequentially increase the delay time of the data strobe signal and generate a pass/fail map in which comparison results corresponding to each delay time are mapped.

In operation S1340, the storage device determines a target delay of the data strobe signa The buffer chip determines a first delay based on a time point at which the comparison result changes from fail to pass and a second delay based on a time point at which the comparison result changes from pass to fail. The buffer chip determines an average value of the first delay and the second delay as the target delay.

## Claims

1. A buffer chip (150, 510) comprising:
a delay circuit (514) configured to delay a data strobe signal (DQS) by a delay time to generate a delayed data strobe signal (DQS_D) based on a target delay;
a sampler (516) configured to sample a random data signal based on the delayed data strobe signal (DQS_D) to generate sampled data (DATA);
a comparator (518) configured to compare internal data with the sampled data (DATA) to generate a comparison result; and
a counter module (520, 522, 524) configured to determine the target delay based on the comparison result,
wherein the counter module (520, 522, 524) comprises a first counter module (520),
wherein the counter module (520, 522, 524) is configured to sequentially receive a plurality of comparison results from the comparator (518) and is configured to accumulate and store the plurality of comparison results,
wherein the first counter module (520) is configured to store a first delay at a time point at which the plurality of the comparison results that are sequentially received change from fail to pass, to store a second delay at a time point at which the plurality of comparison results that are sequentially received change from pass to fail, and to average the first delay and the second delay to generate the target delay, wherein
each comparison result is pass when the corresponding internal data and the corresponding sampled data (DATA) are the same and is fail when the corresponding internal data and the corresponding sampled data (DATA) are not the same; the buffer chip (150, 510) further comprising a reference voltage generator configured to change a reference voltage for sampling the random data signal to generate a changed reference voltage based on a target reference voltage level;
the buffer chip being **characterised in that** the counter module comprises a second counter module and a third counter module;
wherein the second counter module (522) is configured to store a first reference voltage level at a time point at which the comparison results change from fail to pass and to store a second reference voltage level at a time point at which the comparison results change from pass to fail, and to determine an average value of the first reference voltage level and the second reference voltage level as the target reference voltage level, and
wherein the third counter module (524) is configured to provide a pass/fail result on which a control signal is based,
the buffer chip (150, 510) further comprising:
a duty cycle correction circuit (513) configured to adjust a duty cycle of the random data signal based on the control signal.

2. The buffer chip (150, 510) according to claim 1, further comprising:
a clock pin configured to receive a clock signal (CLK) from outside the buffer chip (150, 510); and
a plurality of input/output pins including a first pin (P1) configured to provide the clock signal (CLK) to a plurality of external memory chips and a second pin (P2) configured to receive a data signal (DQ) and the data strobe signal (DQS) from the plurality of external memory chips.

3. The buffer chip (150, 510) of claim 1 or 2, wherein the counter module (520, 522, 524) is configured to:
in response to confirming that the second delay is not stored in the first counter, to provide a delay time increase signal to the delay circuit (514), and
in response to confirming that the second delay is stored in the first counter, not provide the delay time increase signal to the delay circuit (514).

4. The buffer chip (150, 510) of claim 3, wherein the delay circuit (514) is configured to increase the delay time by a preset time based on the delay time increase signal.

5. The buffer chip (150, 510) of any one of claims 1 to 4,
wherein the comparator (518) compares the internal data and the sampled data (DATA) to determine whether the internal data and the sampled data (DATA) are identical and transmits a determination result to the counter module (520, 522, 524).

6. The buffer chip (150, 510) of claim 5, wherein the counter module (520, 522, 524) is configured to:
provide a reference voltage increase signal to the reference voltage generator (529) in response to confirming that the second reference voltage level is not stored in the second counter and
not provide the reference voltage increase signal to the reference voltage generator (529) in response to confirming that the second reference voltage level is stored in the second counter.

7. The buffer chip (150, 510) of claim 6, wherein the reference voltage generator (529) is configured to increase the reference voltage by a preset value based on the reference voltage increase signal.

8. The buffer chip (150, 510) of any one of claims 5 to 7, wherein the duty cycle correction circuit is configured to adjust the duty cycle of the random data signal using a phase interpolation method.

9. The buffer chip (150, 510) of any one of claims 1 to 8, further comprising an input buffer that buffers the random data signal.

10. A storage device (10, 20, 50) comprising:
the buffer chip (150, 510) according to any one of claims 1 to 9; and
a memory device (100, 110, 300, 530) configured to transmit the random data signal and the data strobe signal (DQS) to the buffer chip (150, 510) based on a clock signal (CLK) received from the buffer chip (150, 510),
wherein the sampler (516) is configured to receive the delayed data strobe signal (DQS_D) from the delay circuit (514).

11. The storage device (10, 20, 50) of claim 10, wherein the internal data is the same as random data (502, 532) included in the random data signal and that is stored in the memory device (100, 110, 300, 530), and the internal data is random data (502, 532) in which a logic high section and a logic low section are randomly switched.

12. The storage device (10, 20, 50) of claim 10 or 11, further comprising a controller (200, 400, 500) that is configured to provide the clock signal (CLK) to the buffer chip (150, 510),
wherein the buffer chip (150, 510) is configured to provide the clock signal (CLK) that is obtained from the controller (200, 400, 500) to the memory device (100, 110, 300, 530).

## Patentansprüche

1. Ein Pufferchip (150, 510), umfassend:
eine Verzögerungsschaltung (514), welche derart konfiguriert ist, dass sie ein Datenstrobe-Signal (DQS) um eine Verzögerungszeit verzögert, um auf der Grundlage einer Zielverzögerung ein verzögertes Datenstrobe-Signal (DQS_D) zu erzeugen;
einen Abtaster (516), welcher derart konfiguriert ist, dass er ein zufälliges Datensignal auf der Grundlage des verzögerten Datenstrobe-Signals (DQS_D) abtastet, um abgetastete Daten (DATA) zu erzeugen;
einen Komparator (518), welcher derart konfiguriert ist, dass er interne Daten mit den abgetasteten Daten (DATA) vergleicht, um ein Vergleichsergebnis zu erzeugen; und
ein Zählmodul (520, 522, 524), welches derart konfiguriert ist, dass es die Zielverzögerung auf der Grundlage des Vergleichsergebnisses ermittelt,
wobei das Zählmodul (520, 522, 524) ein erstes Zählmodul (520) umfasst,
wobei das Zählmodul (520, 522, 524) derart konfiguriert ist, dass es nacheinander eine Mehrzahl von Vergleichsergebnissen vom Komparator (518) empfängt und die Mehrzahl von Vergleichsergebnissen akkumuliert und speichert,
wobei das erste Zählmodul (520) derart konfiguriert ist, dass es eine erste Verzögerung zu einem Zeitpunkt speichert, zu dem sich die Mehrzahl der nacheinander empfangenen Vergleichsergebnisse von "nicht bestanden" zu "bestanden" ändert, eine zweite Verzögerung speichert, zu einem Zeitpunkt, zu dem sich die mehreren nacheinander empfangenen Vergleichsergebnisse von "bestanden" auf "nicht bestanden" ändern, und die erste Verzögerung und die zweite Verzögerung zu mitteln, um die Zielverzögerung zu erzeugen,
wobei jedes Vergleichsergebnis "bestanden" ist, wenn die entsprechenden internen Daten und die entsprechenden abgetasteten Daten (DATA) identisch sind, und "nicht bestanden" ist, wenn die entsprechenden internen Daten und die entsprechenden abgetasteten Daten (DATA) nicht identisch sind;
wobei der Pufferchip (150, 510) ferner einen Referenzspannungsgenerator umfasst, welcher derart konfiguriert ist, dass er eine Referenzspannung zum Abtasten des Zufallsdatensignals ändert, um auf der Grundlage eines Zielreferenzspannungspegels eine geänderte Referenzspannung zu erzeugen;
wobei der Pufferchip **dadurch gekennzeichnet ist, dass** das Zählmodul ein zweites Zählmodul und ein drittes Zählmodul umfasst;
wobei das zweite Zählmodul (522) derart konfiguriert ist, dass es einen ersten Referenzspannungspegel zu einem Zeitpunkt speichert, zu dem sich das Vergleichsergebnis von "nicht bestanden" zu "bestanden" ändert, und einen zweiten Referenzspannungspegel zu einem Zeitpunkt speichert, zu dem sich das Vergleichsergebnis von "bestanden" zu "nicht bestanden" ändert, und einen Mittelwert aus dem ersten Referenzspannungspegel und dem zweiten Referenzspannungspegel als den Zielreferenzspannungspegel ermittelt, und
wobei das dritte Zählmodul (524) derart konfiguriert ist, dass es ein "bestanden/nicht bestanden"-Ergebnis liefert, auf dem ein Steuersignal basiert,
wobei der Pufferchip (150, 510) ferner umfasst:
eine Tastverhältnis-Korrekturschaltung (513), welche derart konfiguriert ist, dass sie ein Tastverhältnis des Zufallsdatensignals auf der Grundlage des Steuersignals anpasst.

2. Der Pufferchip (150, 510) nach Anspruch 1, ferner umfassend:
einen Taktpin, welcher derart konfiguriert ist, dass er ein Taktsignal (CLK) von außerhalb des Pufferchips (150, 510) empfängt; und
eine Mehrzahl von Ein-/Ausgangspins, darunter einen ersten Pin (P1), welcher derart konfiguriert ist, dass er das Taktsignal (CLK) an eine Mehrzahl externer Speicherchips liefert, und einen zweiten Pin (P2), welcher derart konfiguriert ist, dass er ein Datensignal (DQ) und das Datenstrobe-Signal (DQS) von der Mehrzahl externer Speicherchips empfängt.

3. Der Pufferchip (150, 510) nach Anspruch 1 oder 2, wobei das Zählmodul (520, 522, 524) derart konfiguriert ist, dass es:
als Reaktion auf die Feststellung, dass die zweite Verzögerung nicht im ersten Zähler gespeichert ist, ein Signal zur Erhöhung der Verzögerungszeit an die Verzögerungsschaltung (514) liefert, und
als Reaktion auf die Feststellung, dass die zweite Verzögerung im ersten Zähler gespeichert ist, das Signal zur Erhöhung der Verzögerungszeit nicht an die Verzögerungsschaltung (514) liefert.

4. Der Pufferchip (150, 510) nach Anspruch 3, wobei die Verzögerungsschaltung (514) derart konfiguriert ist, dass sie die Verzögerungszeit auf der Grundlage des Signals zur Erhöhung der Verzögerungszeit um eine voreingestellte Zeit erhöht.

5. Der Pufferchip (150, 510) nach einem der Ansprüche 1 bis 4,
wobei der Komparator (518) die internen Daten und die abgetasteten Daten (DATA) vergleicht, um festzustellen, ob die internen Daten und die abgetasteten Daten (DATA) identisch sind, und ein Ergebnis dieser Feststellung an das Zählmodul (520, 522, 524) übermittelt.

6. Der Pufferchip (150, 510) nach Anspruch 5, wobei das Zählmodul (520, 522, 524) derart konfiguriert ist, dass es:
dem Referenzspannungsgenerator (529) ein Referenzspannungserhöhungssignal zuführt, wenn bestätigt wird, dass der zweite Referenzspannungspegel nicht im zweiten Zähler gespeichert ist, und
dem Referenzspannungsgenerator (529) kein Referenzspannungserhöhungssignal zuführt, wenn bestätigt wird, dass der zweite Referenzspannungspegel im zweiten Zähler gespeichert ist.

7. Der Pufferchip (150, 510) nach Anspruch 6, wobei der Referenzspannungsgenerator (529) derart konfiguriert ist, dass er die Referenzspannung auf der Grundlage des Referenzspannungserhöhungssignals um einen voreingestellten Wert erhöht.

8. Der Pufferchip (150, 510) nach einem der Ansprüche 5 bis 7, wobei die Tastverhältnis-Korrekturschaltung derart ausgelegt ist, dass sie das Tastverhältnis des Zufallsdatensignals unter Verwendung eines Phaseninterpolationsverfahrens anpasst.

9. Der Pufferchip (150, 510) nach einem der Ansprüche 1 bis 8, ferner umfassend einen Eingangs-Puffer, der das Zufallsdatensignal puffert.

10. Eine Speichervorrichtung (10, 20, 50), umfassend:
den Pufferchip (150, 510) nach einem der Ansprüche 1 bis 9; und
eine Speichervorrichtung (100, 110, 300, 530), welche derart konfiguriert ist, dass sie das Zufallsdatensignal und das Datenstrobe-Signal (DQS) an den Pufferchip (150, 510) auf der Grundlage eines vom Pufferchip (150, 510) empfangenen Taktsignals (CLK) überträgt,
wobei der Abtaster (516) derart konfiguriert ist, dass er das verzögerte Datenstrobe-Signal (DQS_D) von der Verzögerungsschaltung (514) empfängt.

11. Die Speichervorrichtung (10, 20, 50) nach Anspruch 10, wobei die internen Daten mit den im Zufallsdatensignal enthaltenen Zufallsdaten (502, 532) identisch sind und in der Speichervorrichtung (100, 110, 300, 530) gespeichert sind, und bei denen es sich um Zufallsdaten (502, 532) handelt, bei denen ein logisch hoher Abschnitt und ein logisch niedriger Abschnitt zufällig vertauscht sind.

12. Die Speichervorrichtung (10, 20, 50) nach Anspruch 10 oder 11, ferner umfassend eine Steuereinheit (200, 400, 500), welche derart konfiguriert ist, dass sie das Taktsignal (CLK) an den Pufferchip (150, 510) liefert,
wobei der Pufferchip (150, 510) derart konfiguriert ist, dass er das von der Steuereinheit (200, 400, 500) bezogene Taktsignal (CLK) an die Speichervorrichtung (100, 110, 300, 530) liefert.

## Revendications

1. Une puce tampon (150, 510) comprenant :
un circuit de retard (514) configuré pour retarder un signal d'échantillonnage de données (DQS) d'un temps de retard afin de générer un signal d'échantillonnage de données retardé (DQS_D) en fonction d'un retard cible ;
un échantillonneur (516) configuré pour échantillonner un signal de données aléatoire en fonction du signal d'échantillonnage de données retardé (DQS_D) afin de générer des données échantillonnées (DATA) ;
un comparateur (518) configuré pour comparer des données internes aux données échantillonnées (DATA) afin de générer un résultat de comparaison ; et
un module de comptage (520, 522, 524) configuré pour déterminer le délai cible en fonction du résultat de la comparaison,
dans laquelle le module de comptage (520, 522, 524) comprend un premier module de comptage (520),
dans laquelle le module de comptage (520, 522, 524) est configuré pour recevoir séquentiellement une pluralité de résultats de comparaison provenant du comparateur (518) et est configuré pour accumuler et stocker cette pluralité de résultats de comparaison,
dans laquelle le premier module de comptage (520) est configuré pour stocker un premier délai à un instant où la pluralité de résultats de comparaison reçus séquentiellement passe de « échoué » à « réussite », à stocker un deuxième délai à un instant où la pluralité de résultats de comparaison reçus séquentiellement passe de « réussi » à « échoué », et à calculer la moyenne du premier délai et du deuxième délai pour générer le délai cible,
dans laquelle chaque résultat de comparaison est « réussi » lorsque les données internes correspondantes et les données échantillonnées correspondantes (DATA) sont identiques, et est « échoué » lorsque les données internes correspondantes et les données échantillonnées correspondantes (DATA) ne sont pas identiques ;
la puce tampon (150, 510) comprenant en outre un générateur de tension de référence configuré pour modifier une tension de référence destinée à l'échantillonnage du signal de données aléatoires afin de générer une tension de référence modifiée sur la base d'un niveau de tension de référence cible ;
la puce tampon étant **caractérisée en ce que** le module de comptage comprend un deuxième module de comptage et un troisième module de comptage ;
dans laquelle le deuxième module de comptage (522) est configuré pour stocker un premier niveau de tension de référence à un instant où les résultats de la comparaison passent de « échoué » à « réussite », et pour stocker un deuxième niveau de tension de référence à un instant où les résultats de la comparaison passent de « réussite » à « échoué », et pour déterminer une valeur moyenne du premier niveau de tension de référence et du deuxième niveau de tension de référence comme niveau de tension de référence cible, et
dans laquelle le troisième module de comptage (524) est configuré pour fournir un résultat « réussite/échoué » sur lequel se fonde un signal de commande,
la puce tampon (150, 510) comprenant en outre :
un circuit de correction du rapport cyclique (513) configuré pour ajuster le rapport cyclique du signal de données aléatoires en fonction du signal de commande.

2. La puce tampon (150, 510) selon la revendication 1, comprenant en outre :
une broche d'horloge configurée pour recevoir un signal d'horloge (CLK) provenant de l'extérieur de la puce tampon (150, 510) ; et
une pluralité de broches d'entrée/sortie comprenant une première broche (P1) configurée pour fournir le signal d'horloge (CLK) à une pluralité de puces de mémoire externes et une deuxième broche (P2) configurée pour recevoir un signal de données (DQ) et le signal d'échantillonnage de données (DQS) provenant de la pluralité de puces de mémoire externes.

3. La puce tampon (150, 510) selon la revendication 1 ou 2, dans laquelle le module de comptage (520, 522, 524) est configuré pour :
en réponse à la confirmation que le deuxième délai n'est pas stocké dans le premier compteur, fournir un signal d'augmentation du temps de retard au circuit de retard (514), et
en réponse à la confirmation que le deuxième délai est stocké dans le premier compteur, ne pas fournir le signal d'augmentation du temps de retard au circuit de retard (514).

4. La puce tampon (150, 510) selon la revendication 3, dans laquelle le circuit de retard (514) est configuré pour augmenter le temps de retard d'une durée prédéfinie sur la base du signal d'augmentation du temps de retard.

5. La puce tampon (150, 510) selon l'une quelconque des revendications 1 à 4, dans laquelle le comparateur (518) compare les données internes et les données échantillonnées (DATA) afin de déterminer si les données internes et les données échantillonnées (DATA) sont identiques, et transmet un résultat de cette détermination au module de comptage (520, 522, 524).

6. La puce tampon (150, 510) selon la revendication 5, dans laquelle le module de comptage (520, 522, 524) est configuré pour :
fournir un signal d'augmentation de tension de référence au générateur de tension de référence (529) en réponse à la confirmation que le deuxième niveau de tension de référence n'est pas stocké dans le deuxième compteur, et
ne pas fournir le signal d'augmentation de tension de référence au générateur de tension de référence (529) en réponse à la confirmation que le deuxième niveau de tension de référence est stocké dans le deuxième compteur.

7. La puce tampon (150, 510) selon la revendication 6, dans laquelle le générateur de tension de référence (529) est configuré pour augmenter la tension de référence d'une valeur prédéfinie sur la base du signal d'augmentation de tension de référence.

8. La puce tampon (150, 510) selon l'une quelconque des revendications 5 à 7, dans laquelle le circuit de correction du rapport cyclique est configuré pour ajuster le rapport cyclique du signal de données aléatoires à l'aide d'un procédé d'interpolation de phase.

9. La puce tampon (150, 510) selon l'une quelconque des revendications 1 à 8, comprenant en outre un tampon d'entrée qui met en tampon le signal de données aléatoires.

10. Un dispositif de stockage (10, 20, 50) comprenant :
la puce tampon (150, 510) selon l'une quelconque des revendications 1 à 9 ; et
un dispositif de mémoire (100, 110, 300, 530) configuré pour transmettre le signal de données aléatoires et le signal d'échantillonnage de données (DQS) à la puce tampon (150, 510) sur la base d'un signal d'horloge (CLK) reçu de la puce tampon (150, 510),
dans lequel l'échantillonneur (516) est configuré pour recevoir le signal d'échantillonnage de données retardé (DQS_D) provenant du circuit de retard (514).

11. Le dispositif de stockage (10, 20, 50) selon la revendication 10, dans lequel les données internes sont identiques aux données aléatoires (502, 532) incluses dans le signal de données aléatoires et qui sont stockées dans le dispositif de mémoire (100, 110, 300, 530), et les données internes sont des données aléatoires (502, 532) dans lesquelles une section de niveau logique haut et une section de niveau logique bas sont commutées de manière aléatoire.

12. Le dispositif de stockage (10, 20, 50) selon la revendication 10 ou 11, comprenant en outre un contrôleur (200, 400, 500) configuré pour fournir le signal d'horloge (CLK) à la puce tampon (150, 510),
dans lequel la puce tampon (150, 510) est configurée pour fournir le signal d'horloge (CLK) obtenu à partir du contrôleur (200, 400, 500) au dispositif de mémoire (100, 110, 300, 530).
